# EUROPEAN PATENT APPLICATION

(11) **EP 2 524 904 A1**
(43) Date of publication of application: **21.11.2012**
(21) Application number: 10843008.3
(22) Date of filing: 24.12.2010
(51) Int. Cl.: C04B 35/00, C23C 14/34, H01M 4/525

(54) **MANUFACTURING METHOD FOR LiCoO2 SINTERED BODY, AND SPUTTERING TARGET MADE FROM SAME**

(30) Priority: 15.01.2010 JP 2010006765
(71) Applicant: Ulvac, Inc., Chigasaki-shi Kanagawa 253-8543 (JP)
(72) Inventor: KIM, Poong, Susono-shi Shizuoka 410-1231 (JP); SUU, Koukou, Susono-shi Shizuoka 410-1231 (JP); HASHIGUCHI, Shouichi, Tomisato-shi Chiba 286-0225 (JP); MIKASHIMA, Takanori, Tomisato-shi Chiba 286-0225 (JP); OGINOSAWA, Takatoshi, Tomisato-shi Chiba 286-0225 (JP); ITEUE, Wataru, Tomisato-shi Chiba 286-0225 (JP)
(74) Representative: Markfort, Iris-Anne Lucie
(86) International application number: PCT/JP2010/007509
(87) International publication number: WO 2011/086649

(57) **Abstract**

[Object] To provide a manufacturing method for a LiCoO₂ sintered body capable of manufacturing a sintered body having a high density constantly and a sputtering target.

[Solving Means] A manufacturing method for a LiCoO₂ sintered body according to an embodiment of the present invention includes a step of filling a LiCoO₂ powder into a mold. The pressure inside the mold is reduced and the LiCoO₂ powder is applied with pressure sintering in the mold at a temperature of equal to or higher than 800°C and equal to or lower than 880°C. According to the manufacturing method, a LiCoO₂ sintered body having a relative density of 95% or more and an average particle size of equal to or larger than 10 µm and equal to or smaller than 30 µm can be manufactured constantly.

## Description

### Technical Field

The present invention relates to a manufacturing method for a LiCoO₂ sintered body which is provided to form a positive electrode of a thin film lithium secondary cell, for example, and a sputtering target.

### Background Art

In recent years, a thin film lithium secondary cell has been developed. The thin film lithium secondary cell has a configuration that a solid electrolyte is sandwiched between a positive electrode and a negative electrode. For example, LiPON (Lithium Phosphorus Oxynitride) film is used for the solid electrolyte, LiCoO₂ (Lithium Cobalt Oxide) film is used for the positive electrode, and a metal Li film is used for the negative electrode.

As a method of forming a LiCoO₂ film, a method of sputtering a target including LiCoO₂ and forming a LiCoO₂ film on a substrate has been known. In Patent Document 1 which will be described later, although a method of forming a LiCoO₂ film on a substrate by sputtering a LiCoO₂ target having a resistivity of 3 to 10 kΩ/cm by DC pulse discharge is described, a manufacturing method for the LiCoO₂ target is not described in detail.

Generally, manufacturing methods for a sputtering target include a method of molding by dissolving a material and a method of sintering a molded body of a raw material powder. Moreover, examples of a quality demanded for the sputtering target include that, first, its purity is controlled, second, it has a fine crystalline structure and a narrow grain size distribution, third, its composition distribution is uniform, and, fourth, a relative density of a sintered body is high in a case where a powder is used as a raw material. Here, the relative density means a ratio between a density of a porous material and a density of a material having the same composition in a state which has no air holes.

Patent Document 1: Japanese Patent Application Laid-open No. 2008-45213

### Disclosure of the Invention

### Problem to be solved by the Invention

When the sputtering target is configured of a sintered body of a raw material powder, the first to third compositional requirements of a material can be satisfied relatively easily by adjusting the raw material powder. However, it is not easy to attain the high density of the fourth requirement currently because it is greatly affected by unique properties (physical properties and chemical properties) of the material. Particularly, since a LiCoO₂ crystal has a layered structure and it is liable to be peeled off between its layers, there is a problem that it is easy to be broken when forming the sintered body and after forming the sintered body, and that a sintered body having a high density cannot be manufactured constantly.

In view of the circumstances as described above, an object of the present invention is to provide a manufacturing method for a LiCoO₂ sintered body which is capable of manufacturing a sintered body having a high density constantly and a sputtering target.

### Means for solving the Problem

In order to achieve the object described above, the manufacturing method for a LiCoO₂ sintered body according to an embodiment of the present invention includes a step of filling a LiCoO₂ powder into a mold. A pressure inside the mold is reduced. Pressure sintering is applied to the LiCoO₂ powder in the mold at a temperature of equal to or higher than 800°C and equal to or lower than 880°C.

The sputtering target according to an embodiment of the present invention includes a LiCoO₂ sintered body and has a relative density of 95% or more and an average particle size of equal to or larger than 10 µm and equal to or smaller than 30 µm.

### Brief Description of Drawings

[Fig. 1] Fig. 1 is a diagram schematically showing a result of differential thermal analysis of a LiCoO₂ powder described in an embodiment of the present invention.
[Fig. 2] Fig. 2 is a diagram schematically showing a result of thermal desorption spectroscopy of a LiCoO₂ powder described in the embodiment of the present invention.
[Fig. 3] Fig. 3 is a schematic configuration diagram of a typical vacuum hot pressing apparatus
[Fig. 4] Fig. 4 is a schematic configuration diagram of a typical hot isostatic pressing apparatus.
[Fig. 5] Fig. 5 is a diagram showing a profile of a temperature and a load at a time when forming a LiCoO₂ sintered body according to the embodiment of the present invention.
[Fig. 6] Fig. 6 is a diagram showing a relationship between a sintering temperature and a relative density of a sample of the sintered body.
[Fig. 7] Fig. 7 is a diagram showing a state of a change in pressure inside the vacuum hot pressing apparatus which is subjected to the profile of Fig. 5.

### Best Mode(s) for Carrying Out the Invention

A manufacturing method for a LiCoO₂ sintered body according to an embodiment of the present invention includes a step of filling a LiCoO₂ powder into a mold. A pressure inside the mold is reduced. Pressure sintering is applied to the LiCoO₂ powder in the mold at a temperature of equal to or higher than 800°C and equal to or lower than 880°C.

According to the manufacturing method described above, a LiCoO₂ sintered body having a high relative density of 95% or more can be manufactured constantly.

The step of applying pressure sintering to the LiCoO₂ powder can apply a pressure to the LiCoO₂ powder in the mold at a pressure of 200 kg/cm² or more. Accordingly, a LiCoO₂ sintered body having a high relative density of 95% or more can be manufactured constantly.

The step of applying pressure sintering to the LiCoO₂ powder may employ the vacuum hot press method or hot isostatic press method. A LiCoO₂ sintered body having a high relative density of 95% or more can be manufactured constantly, by any method above.

A sputtering target according to an embodiment of the present invention includes a LiCoO₂ sintered body and has a relative density of 95% or more and an average particle size of equal to or larger than 10 µm and equal to or smaller than 30 µm.
Accordingly, it is possible to suppress an occurrence of a particle and perform a stable sputtering by superimposed discharge with direct-current power and high-frequency power.

Hereinafter, the embodiment of the present invention will be described with reference to the drawings.

In this embodiment, a pressure sintering method such as a vacuum hot press method or a hot isostatic press method is employed to manufacture a LiCoO₂ (Lithium Cobalt Oxide) sintered body having a uniform crystalline structure and a high relative density. It is considered that physical properties of an oxide powder greatly affect the sintering method and a sintering condition greatly. Therefore, here, a behavior due to a heating of the LiCoO₂ powder will be described first.

### [Preliminary Review 1: Change in State due to Heating]

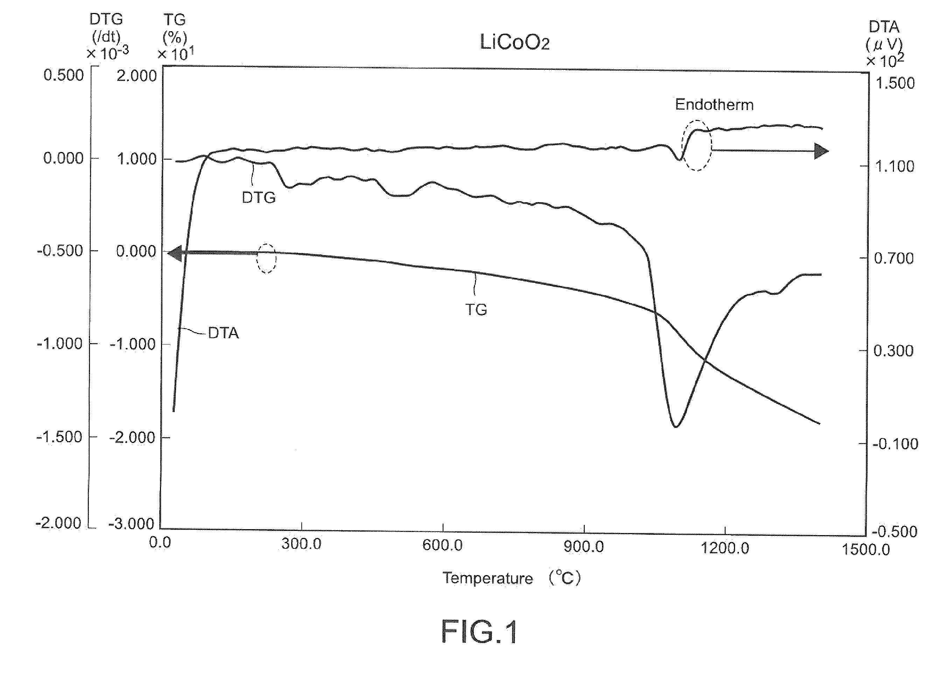

Fig. 1 is an experimental result schematically showing a change in state of a commercially available LiCoO₂ powder ("cell seed (registered trademark) C-5" manufactured by Nippon Chemical industrial Co., LTD.) when it is heated in an Ar atmosphere. As a measuring apparatus, a differential thermal analysis apparatus "TGD-9600" manufactured by ULVAC-RIKO, Inc. was used. When a change in thermogravimetry (TG) of a sample heated in a flow of Ar at a constant rate of temperature increase (20°C/min.) was examined, it was confirmed that there was a slight decrease in weight up to about 1050°C and that a rapid decrease in weight was caused at a temperature higher than that, as shown in Fig. 1. The gradual decrease in weight up to 1050°C is considered to be caused due to a gas release from the sample. Further, since an endothermic reaction was indicated at about 1100°C, it was confirmed that a melting was caused near the temperature.

### [Preliminary Review 2: temperature-programmed desorption properties]

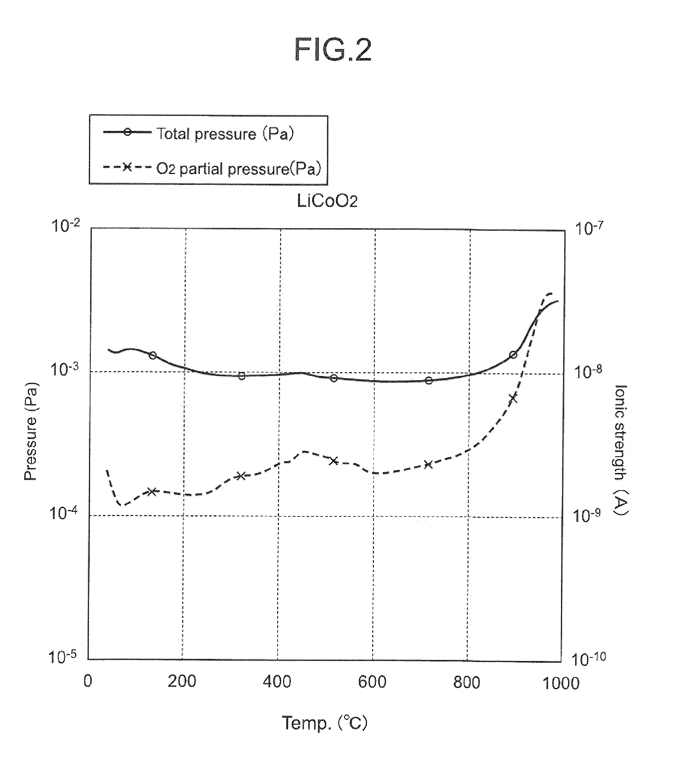

On the other hand, Fig. 2 is an experiment result schematically showing a change in pressure and an emitted gas when the commercially available LiCoO₂ powder described above is heated in a vacuum atmosphere. As a measuring apparatus, a thermal desorption spectroscopy apparatus "TDS-M202P" manufactured by ULVAC-RIKO, Inc. is used. As shown in Fig. 2, total pressure begins to increase in a temperature area higher than 800°C and the change becomes significant from near 900°C. Since a change in total pressure strongly coincides with ionic strength of an oxygen atom, it can be judged that a disassociation of LiCoO₂ is caused to emit an oxygen gas. It should be noted that, although not shown, emission of water, methane, and ammonia is confirmed at near 200°C, 500°C, and 900°C.

### [Result of Preliminary Review]

As described above, a behavior of a LiCoO₂ raw material powder in the flow of Ar and in the vacuum atmosphere was investigated. As a result, it is found that the disassociation of LiCoO₂ is caused from near the temperature of 800°C under a vacuum. Accordingly, a phenomenon which is significantly different from that in the flow of Ar, that is, under a condition which is not a reduced pressure in terms of a pressure, is confirmed. These results are based on the properties of the LiCoO₂, and it is considered that a similar phenomenon is represented in a case of other different commercially available materials.

### [Review of Manufacturing Method]

Next, a manufacturing method for a sintered body will be reviewed. As a sintering method for a powder, a method of burning a powder at ordinary pressure after the powder is compressed to form, and an applying pressure sintering method which performs applying pressure and heating simultaneously, have been known. The former is called a press and sintering method and the latter includes a hot press (HP) method or a hot isostatic press (HIP) method. Generally, an applying pressure sintering method is applied to obtain fine uniform crystal structure such as metal with a high melting point or a sintered body having a high relative density, and is considered to be not suitable as a sintering method of a powder in which a disassociation is caused at a relatively low temperature due to an oxide, as in the LiCoO₂.

The inventors of the present invention deeply reviewed a preliminary experiment of powder properties and tried to find out an optimal condition range in a case where an applying pressure sintering method is applied in order to achieve a higher relative density. The upper limit of the temperature is judged to be 900°C taking into consideration of the disassociation from the result of the preliminary experiment. Further, the optimal sintering temperature is estimated to be within the range of 800°C to 900°C taking into consideration of an improvement of crystalline properties and a progress of sintering. According to an experiment of the inventors of the present disclosure, when the LiCoO₂ powder was sintered under the condition of the sintering temperature of 840°C and a sintering load of 300 kg/cm², a sintered body having a relative density of 96.1% was obtained. An average grain size of this sintered body was about 20 µm.

The value of the sintering load is not particularly high in HP method and is very low in HIP method. Therefore, when the sintered body is produced experimentally by the sintering load, the condition of sintering load in HIP is sufficiently satisfied. Moreover, when the powder is sintered under reduced pressure, a pressure in a hot press chamber starts to increase in the range of the sintering temperature described above. This pressure increase due to a gas release is, however, rather small compared with a molding load and thus can be suppressed sufficiently by the load during sintering.

Based on these results of the reviews, in the following, the manufacturing method for a LiCoO₂ sintered body according to the embodiment of the present invention will be described.

### [Manufacturing Method for Sintered Body by Vacuum Hot Press (HP) Method]

The manufacturing method for a LiCoO₂ sintered body according to this embodiment includes a step of filling a LiCoO₂ powder into a mold, a step of reducing a pressure inside the mold, and a step of applying pressure sintering to the LiCoO₂ powder in the mold.

As a raw material powder, a LiCoO₂ powder having an average particle size (D₅₀) of, for example, equal to or smaller than 20 µm, is used. The LiCoO₂ powder may be a commercially available powder or may be formed by a wet method or a dry method. Examples of the commercially available raw material powder include "cell seed (registered trademark) C-5" or "cell seed (registered trademark) C-5H" manufactured by Nippon Chemical industrial Co., LTD.).

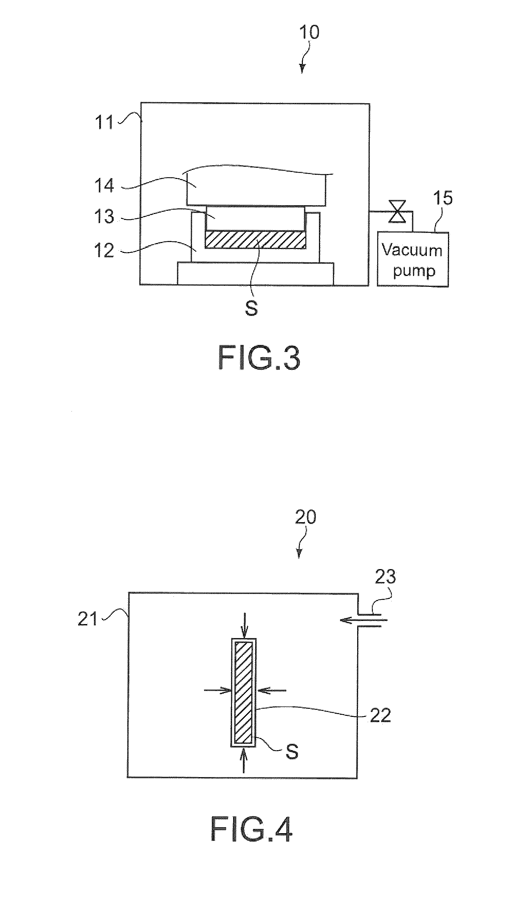

Fig. 3 is a schematic configuration diagram of a vacuum hot pressing apparatus. A vacuum hot pressing apparatus 10 includes a chamber 11, a mold 12 placed in the chamber 11, a punch 13 for compressing a raw material powder filled in the mold 12, a ram 14 that includes a heater and applies pressure to the punch 13, and a vacuum pump 15 that exhausts gas inside the chamber 11. The hot press method is a method to obtain a sintered body S by proceeding sintering by filling a raw material powder into the mold 12 which is formed of carbon (graphite) or metal and applying pressure at a predetermined temperature. In the vacuum hot press method, sintering processing is performed under a reduced atmosphere formed by using the vacuum pump 15.

A pressure in the chamber 11 is not particularly limited, as long as it is lower than atmospheric pressure, and it is, for example, 0.13 Pa to 0.0013 Pa (1×10⁻³ Torr to 1×10⁻⁵ Torr). It is about 0.013 Pa (1×10⁻⁴ Torr) in this embodiment. A welding pressure of the ram 14 also is not particularly limited, and it is, for example, 200 kg/cm² or more. It is 300 kg/cm² in this embodiment. It should be noted that the upper limit of the welding pressure is determined by the performance of a press to be used and is, for example, 1000 kg/cm².

The sintering temperature of the sintered body S is equal to or higher than 800°C and equal to or lower than 880°C. Accordingly, a LiCoO₂ sintered body having a relative density of 95% or more can be obtained constantly. In a case of the sintering temperature of lower than 800°C or more than 880°C, the LiCoO₂ sintered body having a relative density of 95% or more cannot be manufactured constantly. Further, in a case of the sintering temperature of more than 880°C, it is unfavorable because there are concerns of composition variation due to a disassociation of the raw material powder and grain coarsening.

A holding time in the sintering temperature is, for example, 1 to 4 hours, and it is 1 hour in this embodiment. Although it is also possible, of course, to increase the sintering temperature from room temperature to predetermined sintering temperature successively, any temperature lower than the sintering temperature may be held for predetermined time to facilitate the gas release from the raw material powder or the removal of the remaining gas in the mold 12. The rate of temperature increase also is not particularly limited, and it is, for example, 2°C/min. to 10°C/min.

The welding pressure in the sintering step is loaded at a predetermined sintering temperature. The application of pressure may be started when the raw material powder reached the sintering temperature or the application of pressure may be started when a predetermined time has elapsed after the raw material powder reached the sintering temperature. Moreover, in order to emit the gas in the mold 12, the raw material powder may be pressurized preliminarily at least once at a predetermined pressure before reaching the sintering temperature. The preliminary pressurization temperature and the preliminary welding pressure are not particularly limited. For example, the preliminary pressurization temperature can be 450°C to 500°C and the preliminary welding pressure can be 150 kg/cm².

According to the manufacturing method described above, the LiCoO₂ sintered body having a relative density of 95% or more can be manufactured constantly. Accordingly, machine processing can be performed to form the sintered body in a target shape constantly, because the intensity of the sintered body is enhanced and the handling of the sintered body is improved. Further, since durability is obtained also when high power is applied, it is possible to meet a demand for an increase in sputter rate sufficiently.

On the other hand, an average particle size of the sintered body has a strong correlation with the relative density and the mechanical strength of the sintered body. In order to increase the relative density of the sintered body, it is favorable to sinter at a temperature at which the LiCoO₂ crystal is likely to grow. Although the relative density is increased and the mechanical intensity is enhanced as the average particle size becomes large along with proceeding of sintering, the "hard but brittle" property becomes significant and resistance to shock is reduced. Favorably, the average particle size of the LiCoO₂ sintered body according to the embodiment of the present invention is equal to or larger than 10 µm and equal to or smaller than 30 µm.

The sintered body thus obtained is mechanically processed into a predetermined shape and thus provided as a sputtering target. The machine processing of the sintered body includes an outer periphery processing and a surface processing using a lathe. When used as a sputtering target, the sintered body needs to be bonded to a bucking plate. In the bonding, a molten In (indium) may be applied to a bonded surface of the sintered body. A Cu (copper) thin film may be formed in advance on the bonded surface of the sintered body and then the molten In may be applied thereon. After bonding, the target and the bucking plate are washed in a dry environment.

### [Manufacturing Method for Sintered Body by Hot Isostatic Press (HIP) Method]

The manufacturing method for a LiCoO₂ sintered body according to this embodiment also includes a step of filling a LiCoO₂ powder into a mold, a step of reducing a pressure inside the mold, and a step of applying pressure sintering to the LiCoO₂ powder in the mold.

Fig. 4 is a schematic configuration diagram of a hot isostatic pressing apparatus. A hot isostatic pressing apparatus 20 includes a chamber 21 and a canning material (case using thin metal plate and foil) 22 placed in the chamber 21. In the hot isostatic press method, after a raw material powder is filled in the canning material 22 and is degassed, the canning material 22 is sealed. After that, a gas (e.g., argon) which is heated to a predetermined temperature is conducted to the inside of the chamber 21 through a gas conducting slot 23 at a predetermined pressure. Accordingly, a pressurized sintered body S of the raw material powder is obtained.

In the manufacturing method for a LiCoO₂ sintered body by the hot isostatic press method, the sintered body S is manufactured using the same conditions of pressure and temperature as the manufacturing method for a LiCoO₂ sintered body by the vacuum hot press method described above. That is, a pressure in the chamber 11 during sintering is, for example, predetermined 200 kg/cm² to 2000 kg/cm² and it is 300 kg/cm² in this embodiment. Moreover, the sintering temperature of the sintered body S is equal to or higher than 800°C and equal to or lower than 880°C. Accordingly, the LiCoO₂ sintered body having a relative density of 95% or more can be obtained constantly.

### Example

In the following, an example of the present invention will be described, but the present invention does not limited thereto.

### (Example 1)

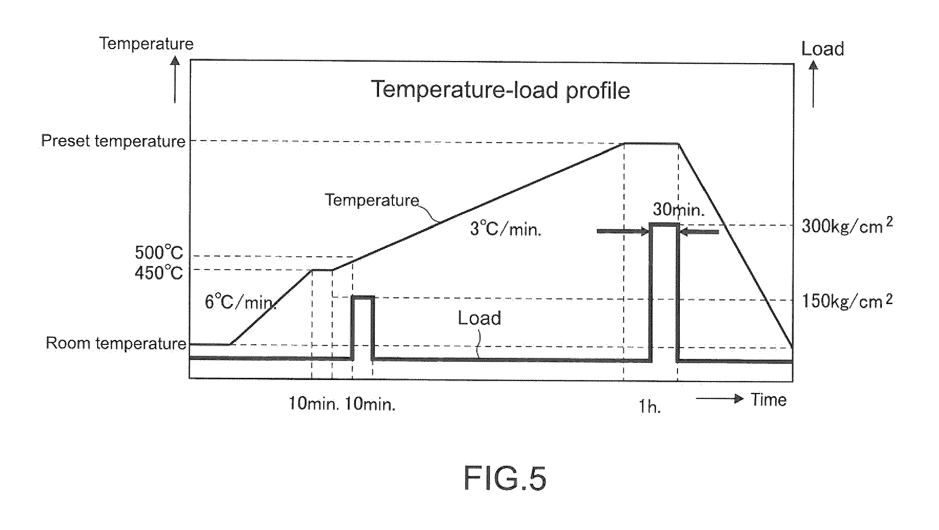

A predetermined amount of a LiCoO2 raw material powder ("cell seed (registered trademark) C-5" manufactured by Nippon Chemical industrial Co., LTD.) having an average particle size (D50; the same shall apply hereinafter) of 5 to 6 µm was filled in a mold uniformly and was placed in a chamber of a vacuum hot pressing apparatus with the mold. After that, a pressure in the chamber was reduced to 0.013 Pa (1×10⁻⁴ Torr). After reaching a target degree of vacuum, a raw material powder was started to be heated using a temperature-load profile shown in Fig. 5. That is, after heating from room temperature to 450°C at a rate of temperature increase of 6°C/min., it was held for 10 minutes at the temperature. After that, it was heated to a set sintering temperature (800°C) at a rate of temperature increase of 3°C/min. At this time, the raw material powder was pressurized at 150 kg/cm² for 10 minutes at a time when reaching the temperature of 500°C. The raw material powder was held at 800°C for 1 hour and then a sintered body was manufactured by applying pressure to the raw material powder at 300 kg/cm² for the last 30 minutes out of the holding time. After that, the sintered body was cooled down to room temperature in the chamber.

When a relative density and an average particle size of the sintered body thus obtained were measured, the relative density was 95.4% and the average particle size was about 10 µm.

It should be noted that the relative density was obtained by a calculation of a ratio of an appearent density and a theoretical density (5.16 g/cm³) of the sintered body. With respect to the appearent density, a volume was obtained by measuring sizes of an outer periphery and a thickness of the obtained sintered body using a vernier caliper, a micrometer, or a three-dimensional measuring instrument after the obtained sintered body was machine processed. Next, a weight of the obtained sintered body was measured by an electric balance and then the appearent density was obtained from the expression of (weight/volume).
A measurement of the average particle size was determined by visual inspection using a cross-sectional SEM image of the sintered body, based on a particle size table of "American Society for Testing and Materials (ASTM) E 112" (Japanese Industrial Standards (JIS) G0551).

### (Example 2)

The sintered body was manufactured in the same condition as the example 1 described above except that the set sintering temperature was 820°C. When the relative density and the average particle size of the sintered body thus obtained were measured, the relative density was 95.9% and the average particle size was about 15 µm.

### (Example 3)

The sintered body was manufactured in the same condition as the example 1 described above except that the set sintering temperature was 840°C. When the relative density and the average particle size of the sintered body thus obtained were measured, the relative density was 97% and the average particle size was about 20 µm.

### (Example 4)

The sintered body was manufactured in the same condition as the example 1 described above except that the set sintering temperature was 860°C. When the relative density and the average particle size of the sintered body thus obtained were measured, the relative density was 96.1% and the average particle size was equal to or smaller than 30 µm.

### (Example 5)

The sintered body was manufactured in the same condition as the example 1 described above except that the set sintering temperature was 880°C. When the relative density and the average particle size of the sintered body thus obtained were measured, the relative density was 95.3% and the average particle size was equal to or smaller than 30 µm.

### (Comparative Example 1)

The sintered body was manufactured in the same condition as the example 1 described above except that the set sintering temperature was 780°C. When the relative density and the average particle size of the sintered body thus obtained were measured, the relative density was 93.8% and the average particle size was equal to or smaller than 10 µm.

### (Comparative Example 2)

The sintered body was manufactured in the same condition as the example 1 described above except that the set sintering temperature was 900°C. When the relative density and the average particle size of the sintered body thus obtained were measured, the relative density was 94.4% and the average particle size was larger than 30 µm.

### (Comparative Example 3)

The sintered body was manufactured in the same condition as the example 1 described above except that the set sintering temperature was 980°C. When the relative density and the average particle size of the sintered body thus obtained were measured, the relative density was 90.1% and the average particle size was larger than 30 µm.

Results of examples 1 to 4 and comparative examples 1 to 3 are shown in table 1 collectively.

**[Table 1]**

| | Sintering temperature (°C) | Relative density(%) | Average particle size (µm) |
|---|---|---|---|
| Example1 | 800 | 95.4 | ≧10 |
| Example2 | 820 | 95.9 | ≒15 |
| Example3 | 840 | 97 | ≒20 |
| Example4 | 860 | 96.1 | ≦30 |
| Example5 | 880 | 95.3 | ≦30 |
| Comparative example1 | 780 | 93.8 | ≦10 |
| Comparative example2 | 900 | 94.4 | >30 |
| Comparative example3 | 980 | 90.1 | >30 |

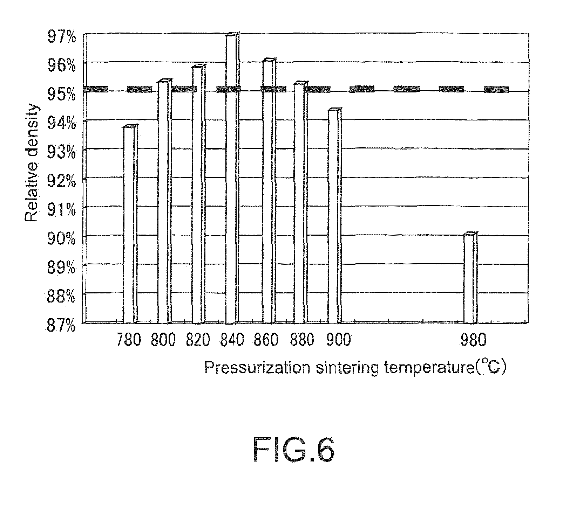

Fig. 6 is a diagram showing a relationship between a set pressurization sintering temperature and the relative density of the obtained sintered body. As shown in table 1 and Fig. 6, it was confirmed that the LiCoO₂ sintered body having a high relative density of 95% or more could be obtained in the range (examples 1 to 4) of the sintering temperature of equal to or higher than 800°C and equal to or lower than 880°C. Particularly, it was confirmed that the very high relative density of more than 96% could be obtained when the sintering temperature was 840°C. Further, in the range of the sintering temperature of equal to or higher than 800°C and equal to or lower than 880°C, it was confirmed that the LiCoO₂ sintered body having an average particle size of equal to or larger than 10 µm and equal to or smaller than 30 µm could be obtained.

On the other hand, any relative density of the sintered bodies according to the comparative examples 1 to 3 in which the sintering temperature is out of the temperature range described above is less than 95%. In the case of the comparative example 1, since the temperature is low, the average particle size is small, but, on the contrary, densification due to sintering does not proceed. On the other hand, in the cases of the comparative examples 2 and 3, since the temperature is too high, crystal grain growth is caused, but densification does not proceed due to generation of disassociation.

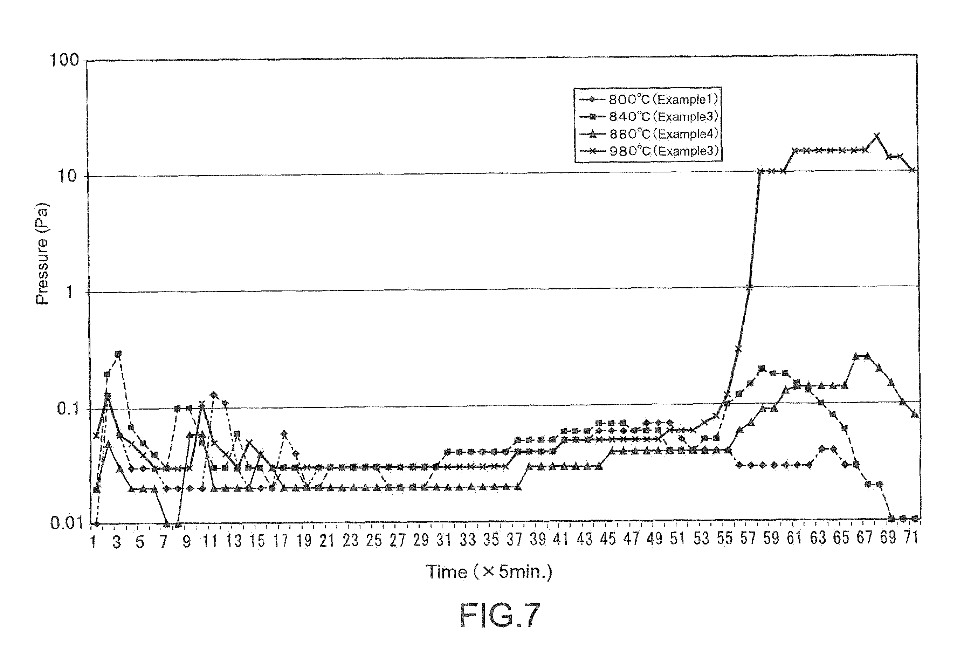

Fig. 7 is a diagram showing a relationship between a heating time and a pressure in a chamber at a time when manufacturing each of the sintered body samples of the example 1, the example 3, the example 4, and the comparative example 3. It shows a state of a change in pressure along with an elapse of time after the heating is started (at a pressure of 0.013 Pa). This change in pressure is derived mainly from an emitted gas from the raw material powder. A degree of vacuum is deteriorated with the temperature rise under the conditions of the examples 1, 3, and 4, and the higher the holding temperature (sintering temperature), the higher a maximum pressure becomes, with the result that the maximum value is 0.25Pa. On the other hand, under the condition of the comparative example 3, the deterioration of the degree of vacuum was significant and the maximum value reached 20 Pa. This result agreed with the inspection result (Fig. 2) of temperature-programmed desorption of the powder completely.

Although the embodiment of the present invention was described, the present invention does not limited thereto, and various modifications can be made based on the technical concept of the present invention.

For example, in the embodiment above, although the pressure during applying pressure sintering is 300 kg/cm², it is not limited thereto, and a higher pressure may be added. Moreover, the same holds true for the rate of temperature increase, the holding time of the pressurization sintering temperature, and the like, and they can be changed as appropriate taking into consideration of a size of the sintered body, productivity, or the like. In relation to the rate of temperature increase, although the rate of temperature increase to the set sintering temperature is 3°C/min. in the example 1 described above, it has been confirmed that the same effect as the example 1 can be obtained under the condition of the rate of temperature increase of 2°C/min. to 4°C/min.

Moreover, under the condition of the pressure sintering identified in the present invention, in a case where the average particle size of the raw material powder is about 1 to 3 µm, or smaller than that, the particle size after the pressure sintering changes, for example, to "equal to or larger than 3 µm and equal to or smaller than 10 µm" which is smaller than the result of "equal to or larger than 10 µm and equal to or smaller than 30 µm" obtained from the raw material of 5 to 6 µm.

### Description of Symbols

- DTA: differential thermal analysis
- TG: thermogravimetry
- DTG: change rate of thermogravimetry
- 10: vacuum hot pressing apparatus
- 20: hot isostatic pressing apparatus
- S: sintered body

## Claims

1. A manufacturing method for a LiCoO₂ sintered body, comprising:
filling a LiCoO₂ powder into a mold;
reducing a pressure inside the mold; and
applying pressure sintering to the LiCoO₂ powder in the mold at a temperature of equal to or higher than 800°C and equal to or lower than 880°C.

2. The manufacturing method for a LiCoO₂ sintered body according to claim 1, wherein
the step of applying pressure sintering to the LiCoO₂ powder includes applying a pressure to the LiCoO₂ powder in the mold at a pressure of 200 kg/cm² or higher.

3. The manufacturing method for a LiCoO₂ sintered body according to claim 2, wherein
the LiCoO₂ powder is applied with pressure sintering by a vacuum hot press method.

4. The manufacturing method for a LiCoO₂ sintered body according to claim 2, wherein
the LiCoO₂ powder is applied with pressure sintering by a hot isostatic press method.

5. A sputtering target including a LiCoO₂ sintered body and having a relative density of 95% or more and an average particle size of equal to or larger than 10 µm and equal to or smaller than 30 µm.
